# EUROPÄISCHE PATENTSCHRIFT

(11) **EP 2 095 698 B1**
(45) Veröffentlichungstag und Bekanntmachung des Hinweises auf die Patenterteilung: **14.09.2011**
(21) Anmeldenummer: 07846377.5
(22) Anmeldetag: 01.12.2007
(51) Int. Cl.: H05K 3/42, H01L 21/768

(54) **VERFAHREN ZUR HERSTELLUNG VON DURCHKONTAKTIERUNGEN UND LEITERBAHNEN**
METHOD FOR THE PRODUCTION OF VIAS AND CONDUCTOR TRACKS
PROCÉDÉ POUR LA FABRICATION DE CONNEXIONS TRANSVERSALES ET DE PISTES CONDUCTRICES

(30) Priorität: 18.12.2006 DE 102006060205
(43) Veröffentlichungstag der Anmeldung: 02.09.2009
(73) Patentinhaber: Forschungszentrum Jülich GmbH, 52425 Jülich (DE)
(72) Erfinder: BOUSACK, Herbert, 52080 Aachen (DE); VIEHWEGER, Kay, 01990 Ortrand (DE)
(86) Internationale Anmeldenummer: PCT/DE2007/002170
(87) Internationale Veröffentlichungsnummer: WO 2008/074291

(56) Entgegenhaltungen:
- EP-A- 1 193 330
- EP-A- 1 281 663
- DE-A1- 19 941 605
- US-A- 4 396 467
- US-A- 6 039 889
- US-A1- 2006 270 095

## Beschreibung

Die Erfindung betrifft ein Verfahren zur Herstellung von Durchkontaktierungen und Leiterbahnen.

Aus US 6,039,889 ist ein Verfahren zur Herstellung von Druckkontaktierungen bekannt, bei dem zunächst blinde Bohrungen im Träger hergestellt werden, um mittels eines durchgängig abgeschiedenen Resists das Wachstum in eine Richtung zu begrenzen.

Es sind verschiedene Halbleiter-Bauelemente bekannt. Als Biochip wird beispielsweise ein Bauelement bezeichnet, mit dem eine große Anzahl biologischer Reaktionen gleichzeitig auf einem Array von Messstellen zum Nachweis von Analyten nachgewiesen werden können. Biochips werden in der molekularen Medizin, der pharmazeutischen Forschung und in der Gendiagnostik eingesetzt. Der Nachweis der Ereignisse erfolgt z. B. elektronisch über Ladungsverschiebungen in Feldeffekttransistoren (FET). Die elektrischen Signale werden hierzu vom Chip über eine Trägerplatine zu einer Auswerteelektronik übertragen.

Die Verbindung eines Chip zu einer Trägerplatine wird z. B. durch Leitkleben oder Verlöten der Kontakte (engl. "Pads") des Chip mit den dafür vorgesehenen Kontaktstellen auf der Trägerplatine hergestellt. Dabei befinden sich die Pads in derselben Ebene mit dem aktiven Array der Feldeffekttransistoren. Der Chip wird hierzu so an der Trägerplatine platziert, dass das Array unter einer Aussparung der Trägerplatine angeordnet liegt und sodann über die Kontakte mit der Trägerplatine verbunden.

Nachteilig ist das Array dann nur noch über die Aussparung in der Trägerplatine für ein Fluid mit Analyten zugänglich. Über die Aussparung wird das Fluid mit dem zu untersuchenden biologischen Material als Analyt mit dem Array in Kontakt gebracht.

In technischen Ausführungen von Biochips übernehmen regelmäßig zusätzliche Bauteile, sogenannte Mikrofluidiken die exakte Portionierung, Positionierung sowie den Transport des Fluids zum Array der Feldeffekttransistoren. Eine Mikrofluidik besteht z. B. aus einem aus Spritzguss gefertigten Kunststoffteil, das zum Zwecke der Positionierung des Fluids exakt und dicht auf den Biochip aufgesetzt wird.

Nachteilig wird die Verbindung des Chip mit der Mikrofluidik durch die oben beschriebene Anordnung, bei der sich die Kontakte und das aktive Array des Chips in derselben Ebene und auf derselben Seite des Chips befinden, räumlich stark beeinträchtigt. Der Grund hierfür ist, dass die über dem aktiven Array liegende Aussparung in der Trägerplatine eine konstruktive Ausgestaltung und Befestigung der Mikrofluidik an den Chip erschwert. Wafer-Scale-Lösungen sind so nicht möglich.

Dieser Nachteil lässt sich beheben, indem man die Pads auf der Unterseite des Chips anordnet. Die Kontakte und das Array sind dann auf zwei sich gegenüberliegenden Seiten des Chips angeordnet. Dadurch ist das Array auf der der Unterseite gegenüberliegenden Oberseite des Chips frei für eine Mikrofluidik zugänglich. Eine elektronische Verbindung des Chip-Arrays auf der Oberseite mit der Trägerplatine auf der Unterseite erfolgt über Durchkontaktierungen des Chips.

Bei Durchkontaktierungen handelt es sich um Mikrobohrungen, welche von einer Oberseite bis zur Unterseite des Halbleiter-Bauelements reichen. Die Durchkontaktierungen können zu einem frühen Zeitpunkt der Prozessierung im Wafer und somit noch vor der Herstellung der Chips oder aber nach ihrer Herstellung bereitgestellt werden.

Die Durchkontaktierungen sind durch Metallabscheidung elektrisch leitend, und werden durch Leiterbahnen auf der Oberseite bzw. auf der Unterseite eines Wafers bzw. eines Chips ergänzt. Die Leiterbahnen führen beispielsweise von der Oberseite eines Chips ausgehend von den Durchkontaktierungen zu einem Array an Feldeffekttransistoren. Auf der der Oberseite gegenüberliegenden Unterseite sind die Durchkontaktierungen über Leiterbahnen mit einer Auswerteelektronik verbunden. Auf diese Weise können elektrische Signale ausgehend von Feldeffekttransistoren auf der Oberseite durch die Durchkontaktierungen hindurch auf die Unterseite eines Chips geleitet werden, um sie einer Auswerteelektronik zuleiten zu können. Hierzu sind Leiterbahnen entweder direkt auf der Unterseite des Chips angeordnet und mit der Auswerteelelctronik verbunden oder sie kontaktieren diese über zusätzliche Leiterbahnen auf der Trägerplatine.

Bei auf diese Weise hergestellten Chips steht vorteilhaft die gesamte Oberseite für einen Kontakt mit einer Mikrofluidik zur Verfugung. Bei der Herstellung von Durchkontaktierungen und Leiterbahnen kommen verschiedene Verfahren zur Anwendung. Die notwendigen Bohrungen werden durch ein Boschverfahren oder durch eine Laserablation bereitgestellt.

Die Gräben für die Leiterbahnen werden regelmäßig geätzt. Zur Herstellung der Durchkontaktierungen und der Leiterbahnen werden die Bohrungen und die Gräben mit einer metallischen Füllung versehen. Die Füllung erfolgt z. B. durch galvanische Abscheidung von Kupfer. Dabei handelt es sich um ein zweistufiges Verfahren. Für die galvanische Abscheidung des Metalls wird in einem ersten Schritt eine dünne Keimschicht abgeschieden. Die Keimschicht liefert einen niederohmigen Leiter für den Galvanisierungsstrom, der den Prozess antreibt, und erleichtert die Filmbildung. Die galvanische Abscheidung des Metalls erfolgt sodann durch in Kontaktbringen der Keimschicht mit einem kupferhaltigen Galvanisierungsbad und Anlegen eines Stromes bis etwa 10A/dm². Eine Galvanisierungslösung ist z. B. der DE 199 41 605 A1 entnehmbar.

Für die Keimschicht wird z. B. ebenfalls Kupfer verwendet, da dieses eine hohe Leitfähigkeit aufweist. Die Keimschicht besteht in der Regel aus demselben Material, wie das hierauf abgeschiedene Metall und wird vor der galvanischen Abscheidung des Metalls abgeschieden.

Zur Herstellung der Durchkontaktierung wird Metall von einer Öffnung bis zur gegenüberliegenden Öffnung auf der gegenüberliegenden Seite derselben Bohrung abgeschieden. Die Keimschicht wird dabei durch das abgeschiedene Metall verstärkt, bis das Metall mit der Zeit die Bohrung vollständig auffüllt.

Bei diesem auch als Dual-Damascene-Verfahren bezeichneten Verfahren werden zunächst die Bohrungen für die Durchkontaktierungen und die Gräben für die Leiterbahnen geätzt. In einem zweiten Arbeitsschritt wird ein Isolationsfilm in Form einer Barriereschicht von etwa hundert Atomlagen abgeschieden, um das Eindringen des Kupfers in das Halbleitermaterial zu verhindern. In einem dritten Arbeitsschritt wird eine dünne Metallschicht als Keimschicht abgeschieden. Anschließend werden galvanisch in einem einzigen Arbeitsgang sowohl die Durchkontaktierungen als auch die Leiterbahnen auf der Keimschicht aufgewachsen. Durch chemisch-mechanisches Polieren wird der Wafer abschließend planarisiert und überschüssiges Kupfer von der Oberfläche des Wafers entfernt.

Auf die so hergestellte plane Fläche wird sodann eine Oxid-Schicht zur Isolierung aufgebracht und der Vorgang wiederholt. Auf diese Weise kommen Mehrlagenverdrahtungsebenen in Silizium zu Stande.

Nachteilig umfasst das Dual-Damascene-Verfahren ein Polieren der Oberfläche, da überschüssiges Kupfer von der Oberfläche des Wafers entfernt werden muss. Sind die Gräben für die Leiterbahnen aufgefüllt, muss das überschüssige Kupfer, das sich auf der Oberseite des Wafers während des Verfahrens weiter ablagert, durch Polieren wieder entfernt werden.

Aufgabe der Erfindung ist es daher, ein Verfahren bereit zu stellen, mit dem Durchkontaktierungen und Leiterbahnen einfacher, schneller und preiswerter hergestellt werden können.

Die Aufgabe wird durch ein Verfahren gemäß Hauptanspruch gelöst. Vorteilhafte Ausgestaltungen ergeben sich aus den darauf rückbezogenen Patentansprüchen.

Das erfindungsgemäße Verfahren zur Herstellung von Durchkontaktierungen und Leiterbahnen eines Trägermaterials mittels galvanischer Abscheidung eines Metalls, sieht die nachfolgenden Schritte vor:
- auf der Oberseite und der Unterseite des Trägermaterials (11) werden insbesondere im Bereich um die Bohrungen (15) für die Durchkontaktierungen (14, 17, 19) elektrisch voneinander isolierte Bereiche einer Keimschicht (13, 16) angeordnet,
- es wird ein elektrischer Kontakt der Keimschicht (13) auf einer ersten Seite des Trägermaterials (11) zu einem Galvanisierungsbad bereit gestellt und Metall auf dieser Keimschicht (13) abgeschieden,
- durch Anordnung eines Begrenzungselements (18) mit einem Abstand (X) zur ersten Seite des Trägermaterials wird die maximale Schichtdicke des abgeschiedenen Metalls auf den Abstand begrenzt,
- die Abscheidung von Metall wird fortgesetzt, bis es die auf der zweiten Seite des Trägermaterials (11) angeordnete Keimschicht (16) kontaktiert,
- die Durchkontaktierungen (14, 17, 19) und die Leiterbahnen (20) auf der zweiten Seite des Trägermaterials (11) werden durch weitere Abscheidung gleichzeitig fertig gestellt.

Die Keimschicht wird auf verschiedenen Seiten des Trägermaterials insbesondere im Bereich der Bohrungen für die Durchkontaktierungen elektrisch voneinander isoliert angeordnet.

Es wird eine Keimschicht gewählt, welche für das abzuscheidende Metall geeignet ist. Die Abscheidung des Metalls auf der Keimschicht wird fortgesetzt, bis dieses in den Bohrungen die auf der der ersten Seite gegenüberliegenden zweiten Seite angeordnete Keimschicht erreicht und diese elektrisch kontaktiert. Vorteilhaft kann der Verschluss der Durchkontaktierungen und die Leiterbahnen auf der zweiten Seite des Trägermaterials dann durch Abscheidung des Metalls gleichzeitig fertig gestellt werden.

Der Verschluss der Bohrungen zur Herstellung der Durchkontaktierungen und die Herstellung der Leiterbahnen auf der zweiten Seite des Trägermaterials wird daher in einem einzigen abschließenden Verfahrensschritt ohne eine nachteilige Planarisierung zur Entfernung überschüssigen Metalls auf der zweiten Seite des Trägermaterials hergestellt. Da auf der zweiten Seite des Trägermaterials die Keimschicht in den Bereichen der Leiterbahnen in Kontakt mit der Keimschicht in den Bereichen der Bohrungen der Durchkontaktierungen steht, wird das Metall auf der zweiten Seite des Trägermaterials in einem einzigen Arbeitsschritt abgeschieden.

Mit dem Begriff "Seite eines Trägermaterials" ist in der Regel die flächige Ober- bzw. Unterseite des Trägermaterials gemeint, und in der Regel nicht dessen Randbereich.

Als Trägermaterial kann beispielsweise ein Wafer, eine Leiterplatte oder auch ein Chip gewählt werden.

In einer vorteilhaften Ausgestaltung der Erfindung wird Kupfer sowohl zur Bildung der Keimschicht als auch bei der galvanischen Abscheidung zur Herstellung der Durchkontaktierungen bzw. Leiterbahnen als Metall ausgewählt.

Kupfer hat sich für beide Zwecke gleichermaßen als geeignet herausgestellt, wie der DE 199 41 605 A1 zu entnehmen ist. Die in dieser Druckschrift angegebenen Lösungen werden bevorzugt auch für das vorliegende Verfahren verwendet. Alternativ können aber auch Kupferelektrolyten auf Cyanid-, Tetrafluoroborat- und Pyrophosphat-Basis eingesetzt werden.

Die galvanische Abscheidung des Metalls zur Herstellung der Leiterbahnen erfolgt in einer weiteren vorteilhaften Ausgestaltung der Erfindung nur an denjenigen Stellen der Keimschicht, welche nicht mit einem Resist abgedeckt sind. Hierzu werden mittels Lithographie die Stellen der Keimschicht auf der Oberfläche des Trägermaterials, an denen keine Abscheidung von Metall erfolgen soll, mit einem Resist abgedeckt. Dadurch entfällt vorteilhaft der Schritt, wonach die Keimschicht bereits vor der galvanischen Abscheidung des Metalls strukturiert oder teilweise wieder entfernt werden muss.

Besonders vorteilhaft wird hierzu ein Festresist gewählt. Nach der galvanischen Abscheidung des Metalls zur Herstellung der Leiterbahnen und Durchkontaktierungen wird der Festresist entfernt und die dadurch freigelegte Keimschicht weggeätzt. Es verbleiben dann nur noch mit galvanisch abgeschiedenem Metall bedeckte Bereiche der Keimschicht auf dem Trägermaterial. Die Ätzung des Metalls der Keimschicht auf dem Trägermaterial kann ganzflächig erfolgen. Das heißt, es wird ganzflächig das Metall solange weggeätzt, bis die freigelegte Keimschicht entfernt ist. An den galvanisch beschichteten Flächen wird im gleichen Maße Metall geätzt. Da diese Schicht im Verhältnis zur Keimschicht aber viel dicker ist, fällt der relativ geringfügige Abtrag hieran nicht ins Gewicht.

Alternativ hierzu besteht die Möglichkeit, die Keimschicht gemäß des Layouts vor der galvanischen Abscheidung durch ein Lift-Off Verfahren zu strukturieren.

In einer besonders vorteilhaften Ausgestaltung der Erfindung wird zur Herstellung besonders dauerhafter Durchkontaktierungen der Bereich um die Öffnungen der Bohrungen auf einer oder vorzugsweise auf beiden Seiten des Trägermaterials vor der galvanischen Abscheidung des Metalls zusätzlich mit einer beispielsweise ringförmigen Keimschicht versehen.

Dadurch wird besonders vorteilhaft bewirkt, dass die Durchkontaktierungen förmlich wie Nieten ausgebildet werden.

Es wird ein Begrenzungselement an der ersten Seite des Trägermaterials, an der zu Beginn der Abscheidung der elektrische Kontakt der Keimschicht zum Galvanisierungsbad bereit gestellt wurde, angeordnet. Das Begrenzungselement dient vorteilhaft der Halterung des Trägermaterials während der Galvanisierung. Es weist hierzu etwa die Größe des Trägermaterials auf. Das Begrenzungselement weist eine flächige Ebene auf und wird bei etwa gleicher Geometrie zum Trägermaterial angeordnet. Das Begrenzungselement verhindert besonders vorteilhaft, dass Metall während der galvanischen Abscheidung räumlich unbegrenzt auf der Keimschicht der ersten Seite des Trägermaterials abgeschieden wird. Die maximale Schichtdicke des an der ersten Seite des

Trägermaterials abgeschiedenen Metalls und insbesondere des aus den Öffnungen der Bohrungen auf dieser Seite des Trägermaterials hinausragenden Metalls wird hierdurch vorteilhaft auf den Abstand des Trägermaterials zum Begrenzungselement begrenzt. Dadurch wird vorteilhaft auch eine Planarisierung auf der ersten Seite des Trägermaterials entbehrlich. Die Dicke des auf der ersten Seite des Trägermaterials abgeschiedenen Metalls entspricht dem Abstand zum Begrenzungselement.

Im Weiteren wird die Erfindung an Hand von Ausführungsbeispielen und der beigefügten Figuren 1 bis 2 näher beschrieben.

Es zeigen:
- Fig. 1A-1D:: Schematische Darstellung des erfindungsgemäßen Verfahrens in vier Schritten (Fig. 1A-1D). Darstellung der Verfahrensabschnitte jeweils in Aufsicht (Fig. 1A1) bis 1D1), oben) bzw. im Schnitt entlang der Achse A-A (Fig. 1A2) bis 1D2), unten).
- Fig. 2:: Waferhalterung mit Begrenzungselement.
- Fig. 3:: Schematische Darstellung eines Biochip, hergestellt nach dem erfindungsge- mäßen Verfahren. Darstellung in Aufsicht (oben) bzw. im Schnitt entlang der Achse A-A (unten).

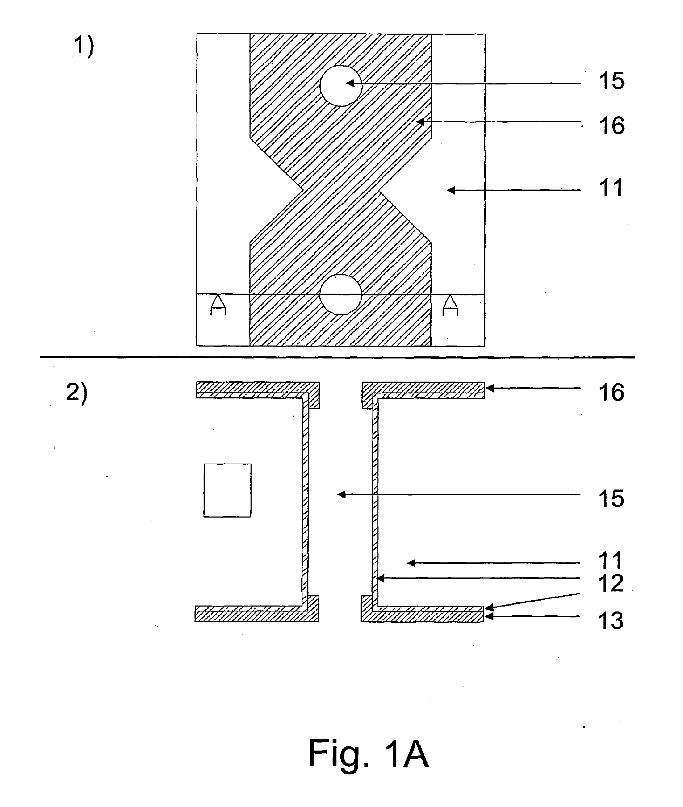

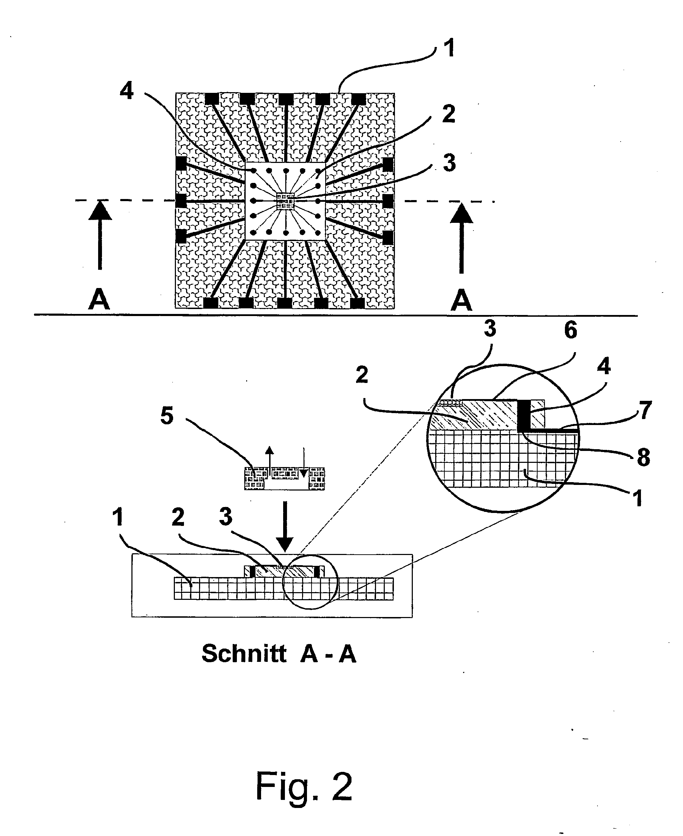

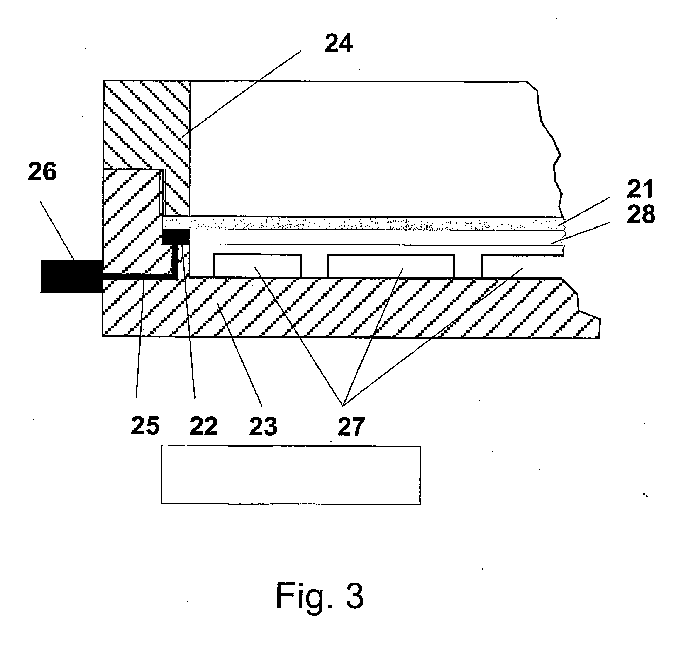

Gleiche Bezugszeichen in den Fig. 1A-1D bezeichnen gleiche Teile. Die Bezugszeichen der Fig. 2 und 3 sind hiervon ausgenommen.

### Erstes Ausführungsbeispiel:

In Fig. 1A1) sind in Aufsicht zwei benachbarte Bohrungen 15 in einem Wafer 11 als Trägermaterial dargestellt, von denen nur die obere mit Bezugszeichen 15 versehen ist. Der schraffierte Bereich im oberen Teil der Fig. 1A1) bis 1C1) gibt den Bereich der Ätzgräben für die Leiterbahnen auf der Oberseite des Wafers 11 an, welcher mit einer Keimschicht 16 beschichtet wurde. Die Oberseite des Wafers 11 entspricht anspruchsgemäß der zweiten Seite des Trägermaterials.

Die im oberen Teil der Figuren 1A1) bis 1D1) dargestellte Einschnürung ist Bestandteil der Ätzgräben, welche mit Keimschicht 16 bedeckt wurden. Die Keimschicht 16 im Bereich der Leiterbahnen kann lateral verformt sein und selbstverständlich auch Richtungsändenmgen aufweisen. Die Keimschicht auf der dieser gegenüberliegenden Unterseite des Wafers 11 ist mit Bezugszeichen 13 versehen. Die Unterseite des Wafers 11 entspricht anspruchsgemäß der ersten Seite des Wafers.

Der Wafer 11 weist Bohrungen 15 in gewünschter Anzahl und Anordnung auf. Der Durchmesser der Bohrungen 15 im Wafer 11 beträgt etwa 20 µm.

Die Gräben für die Leiterbahnen wurden geätzt. Die Ätzgräben auf der Oberseite des Wafers 11 führen von den Bohrungen 15 zu den Feldeffelcttransistoren, (nicht dargestellt) und verbinden diese Elemente miteinander.

Der Wafer 11 wurde zunächst mit einer Diffusionsbarriere 12, umfassend Tantalnitrid (TaN) mit Atomic Layer Deposition (ALD) beschichtet, s. Fig. 1A2) bis 1D2). Die Diffusionsbarriere 12 weist eine Dicke von etwa 10 bis 20 Nanometer auf. Sie ist auf beiden Waferoberflächen sowie auch im Innenbereich der Bohrungen 15 angeordnet und kleidet diese vollständig aus. Die Diffusionsbarriere 12 dient der Verhinderung der Diffusion des später abzuscheidenden Metalls für die Leiterbahnen und der Durchkontaktierungen in das Halbleitermaterial des Wafers 11. Sie weist vorteilhaft haftvermittelnde Wirkung zwischen dem Wafer 11 und dem Metall auf.

Auf die Diflhsionsbarriere 12 werden sowohl auf der Ober- als auch auf der Unterseite des Wafers 11 je eine gleichmäßig homogene Keimschicht 16, 13 mittels Physical Vapor Deposition (PVD) abgeschieden. Die Keimschicht 16 auf der Oberseite des Wafers ist dadurch elektrisch isoliert zur Keimschicht 13 auf der Unterseite des Wafers 13. Die Keimschicht 13, 16 besteht aus einer etwa 25 Nanometer dicken Schicht Kupfer.

Das Kupfer der Keimschichten 13, 16 darf die Innenwand der Bohrung 15 nicht vollständig bedecken, da sonst eine elektrische Kontaktierung beider Keimschichten 13, 16 gegeben wäre, was während der galvanischen Abscheidung auf Keimschicht 16 zu inakzeptabler Dicke des Metalls auf der Oberseite des Wafers 11 führen würde.

Die Keimschicht 16, 13 wird sodann mit einem Positivlack als Festresist bedeckt (nicht dargestellt). Ein Festresist wird gewählt, da ein Flüssigresist in die Bohrungen 15 eindringen und diese verschließen könnte, so dass die Abscheidung des Metalls nicht mehr erfolgen könnte.

Der Festresist (etwa 40 µm dick) wird hierzu in einem ersten Schritt mit einem Rollenbeschichter auf die Keimschichten 16, 13 auflaminiert. Die Strukturierung des Festresist erfolgt mittels optischer Lithographie. Die Lithographie beinhaltet alle notwendigen Schritte vom Aufbringen des Festresists über die Belichtung und die Entwicklung des Resists. Zwischen den Schritten werden verschiedene Wärmebehandlungen durchgeführt, um die Haftfestigkeiten zu verbessern, Lösungsmittel auszutreiben und um den Festresist widerstandsfähiger gegen chemische Lösungen zu machen.

Die belichteten Bereiche im Positivlack werden mittels Ätzung mit 1 %-iger NatriumcarbonatLösung, beidseitig entlang der Öffnungen der Bohrungen 15 und im Bereich der Leiterbahnen 16 auf der Oberseite sowie gegebenenfalls auch auf der Unterseite des Wafers herausgelöst. Dadurch treten freigelegte Bereiche Keimschicht 13, 16 auf der Oberfläche des Wafers 11 hervor, auf denen nachfolgend die Abscheidung des Metalls erfolgt.

In Fig. 1A ist der Ausgangspunkt des Verfahrens zur Herstellung der Durchkontaktierungen und der mit diesen verbundenen Leiterbahnen dargestellt. Der Wafer 11 weist zahlreiche Bohrungen 15 auf, die durch den Wafer 11 hindurchführen.

Es wird ein elektrischer Kontakt zu einem Galvanisierungsbad (nicht dargestellt) nur an die Keimschicht 13 der Unterseite des Wafers 11 angelegt.

Der Wafer 11 wird während der Abscheidung des Kupfers 14 an seiner Unterseite mit Galvanisierungslösung umspült bzw. in ein Galvanisierungsbad mit kupferhaltiger Lösung gelegt.

Die Abscheidung des Metalls erfolgt strombegrenzt. Je nach chemischer Basis des Elektrolyten bewegen sich die Stromdichten bis etwa 6A/dm². Wenn der Wert überschritten wird, zersetzt sich der Elektrolyt. Die abgeschiedenen Schichten sind dann untauglich bezüglich Haftfestigkeit, Stromleitung und Aussehen. Ein Schwefelsäure-Elektrolyt wird bevorzugt im Bereich bis 4 A/dm², maximal bis 6 A/dm², betrieben. Die Spannung stellt sich dabei je nach Elektrolyt-Basis ein.

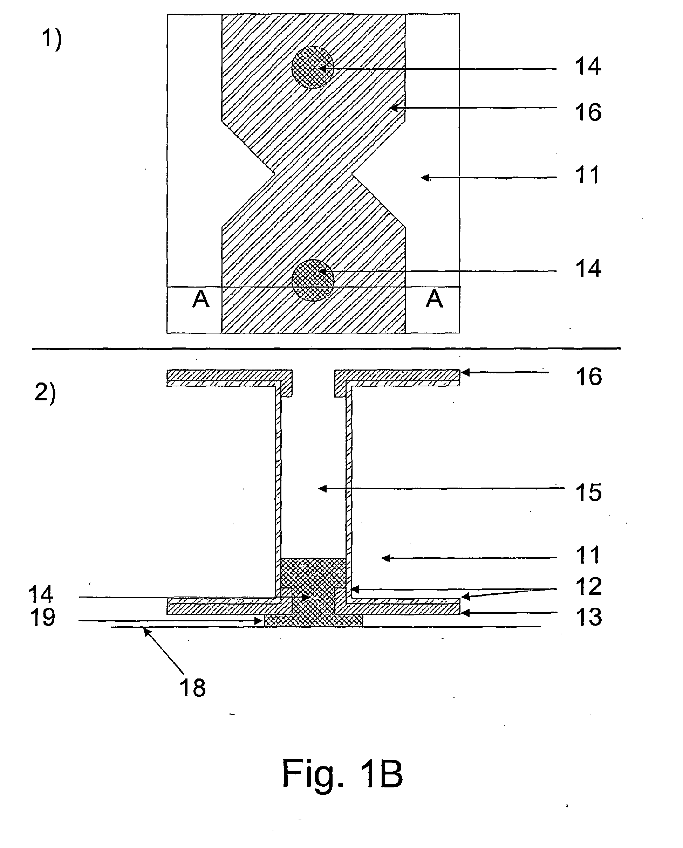

Aus der Galvanisierungslösung wird das Kupfer 14 galvanisch auf die Keimschicht 13 im Innenbereich der Öffnungen 15 sowie auf allen nicht von Festresist bedeckten Bereichen von Keimschicht 13 auf der Unterseite von Wafer 11 abgeschieden (Fig. 1B1), 1B2)). Diese Metallabscheidung erfolgt in allen Richtungen gleichmäßig an den Strom führenden Bereichen der Unterseite des Wafers 11. Somit erfolgt auch ein Wachstum in der Bohrung 15 in Richtung zur Oberseite des Wafers 11 (Fig. 1B2)). Während das Kupfer 14 abgeschieden wird, füllt es die Bohrungen 15 mehr und mehr auf.

Über ein Begrenzungselement 18 aus Vollmaterial mit gleicher Geometrie wie die Wafer-Oberfläche wird gleichzeitig über den Abstand des Elements 18 zum Wafer 11 die maximale Dicke des abgeschiedenen Kupfers 14 aus den Öffnungen der Bohrungen 15 auf der ersten Seite des Wafers hinaus begrenzt (Fig. 1B1)). Sobald das abgeschiedene Kupfer 14 außerhalb der Öffnungen 15 im unteren Bereich 19 das Begrenzungselement 18 erreicht, ist dessen maximale Ausdehnung aus der Bohrung 15 über die Öffnungen 15, an der die Abscheidung auf der Unterseite von Wafer 11 begann, erreicht. Dieser Mindestabstand x beträgt vorliegend etwa 40 µm bis 100 µm.

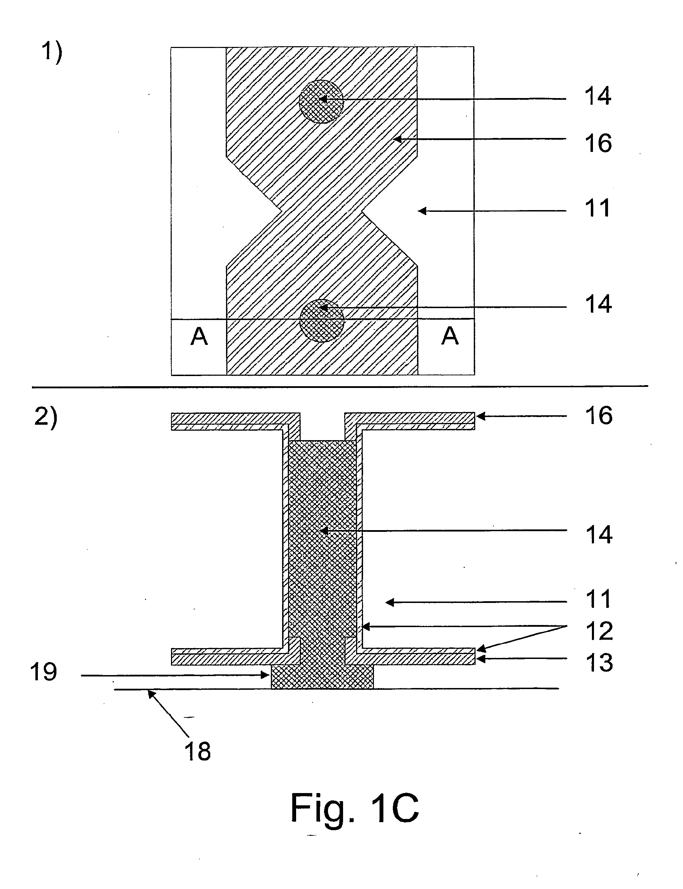

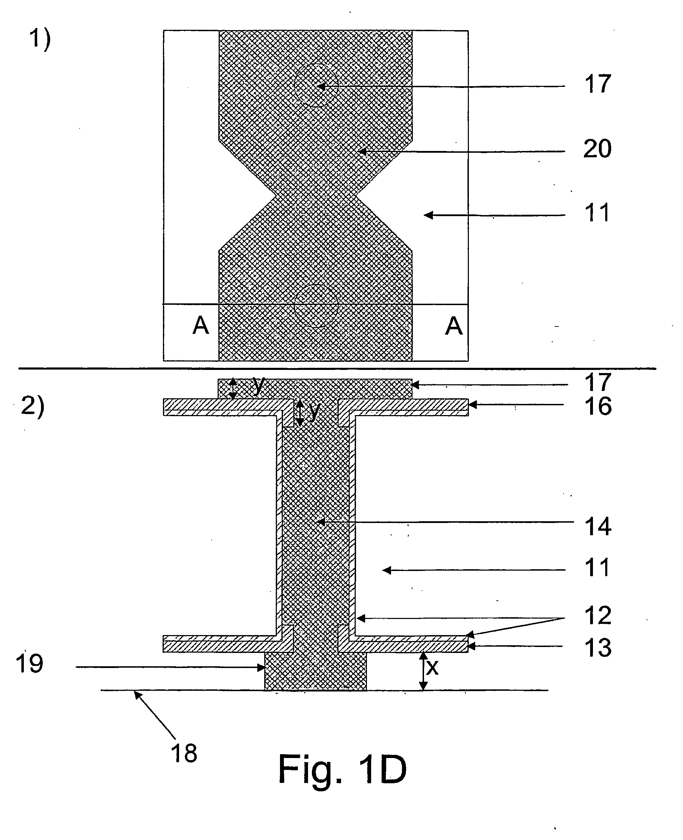

Die galvanische Abscheidung des Kupfers 14 wird weiter fortgesetzt, bis es in den Bohrungen 15 die Keimschicht 16 in den gegenüberliegenden Öffnungen auf der Oberseite des Wafers 11 erreicht hat (Fig. 1C1)). Dadurch ist der elektrische Kontakt zu der Keimschicht 16 auf der zweiten Seite, vorliegend der Oberseite des Wafers 11, hergestellt. Kupfer wird daher im Weiteren nicht nur im oberen Bereich zum Verschluss der Bohrung 15 und zur Herstellung der Durchkontaktierung 14, 17, 19, sondern auch entlang der auf der Oberseite des Wafers 11 angeordneten und nicht von Festresist bedeckten Keimschicht 16 im Bereich der Ätzgräben zur Bildung der Leiterbahnen abgeschieden (Fig. 1D1)).

Die Durchkontaktierung 14, 17, 19 wird somit aus Anteilen Kupfer in den Bereichen 19 und 17 unterhalb und oberhalb des Wafers 11 sowie aus dem Kupfer in den Bohrungen 15 gebildet. Die Leiterbahnen 20 werden aus abgeschiedenem Kupfer im Bereich der Ätzgräben zwischen den Bohrungen 15 gebildet, s. Fig. 1D1).

Auf diese Weise wird der Rest der Durchkontaktierungen sowie die Leiterbahnen.auf der Oberseite des Wafers 11 in einem Schritt durch Abscheidung des Kupfers fertig gestellt. Die galvanische Abscheidung wird fortgesetzt, bis die gewünschte Schichtdicke des Kupfers auf der Oberseite des Wafers 11 erreicht ist. Dies entspricht etwa der Ausdehnung y der in die Bohrungen 15 hineinragenden Keimschicht 16, welche identisch ist zu der Schichtdicke y der Leiterbahnen 20 auf der Oberseite des Wafers 11.

Die galvanische Abscheidung von Kupfer 14 findet nur an den nicht mit Festresist abgedeckten Bereichen der Keimschichten 13, 16 statt. Nach der galvanischen Abscheidung wird der Festresist entfernt und die freigelegten Bereiche an Keimschicht 13, 16 chemisch weggeätzt.

Über die Zeitdauer der Galvanisierung wird die gewünschte Dicke der Leiterbahn 20 unabhängig von der Tiefe der Bohrung 15 eingestellt.

### Zweites Ausführungsbeispiel:

Das Verfahren wird wie im ersten Ausführungsbeispiel durchgeführt, mit Ausnahme, dass um die Bohrung herum ringartig verstärkt Keimschicht auf der Ober- und Unterseite des Wafers angeordnet wird. Hierzu wurde der Resist auf Vorder- und Rückseite so strukturiert, dass sich die Form eines Nietes ausbildet. Strukturiert bedeutet, dass man um die Bohrungen herum konzentrisch an Ober- und Unterseite einen Ring offen lässt. Die Breite des Rings hängt vom Platz zwischen den einzelnen Bohrungen ab und beträgt etwa 1/3 des Durchmessers der Bohrungen.

Hierdurch wird Kupfer im Bereich der Öffnungen der Bohrung auf der Oberseite und auf der Unterseite des Wafers aufgewachsen und eine Durchkontaktierung in Form eines Niets ausgebildet, so dass dieser mechanisch besser im Wafer verankert ist. Diese Ausführung hat dann nicht die Aufgabe, zwei Durchkontaktierungen mit einer Leiterbahn zu verbinden, sondern soll nur einzeln angeordnete Kontaktpunkte bilden.

Für das erfindungsgemäße Verfahren kann eine Waferhalterung 23, wie in Fig. 2 dargestellt, verwendet werden. In Fig. 2 zeigt Bezugszeichen 21 den Wafer, welcher auf einem metallischen Kontaktring 22 aufgelegt ist. Wafer 21 wird durch einen Feststellring 24 fixiert. Eine Spannungsquelle (nicht dargestellt) stellt über Kontakt 26 und Leitung 25 einen Kontakt der auf dem Wafer 21 angeordneten Keimschicht (nicht dargestellt) zu der den Wafer 21 auf der Unterseite umspülenden Galvanierungslösung her. Für den Zutritt der Lösung sind Öffnungen 27 in der Waferhalterung 23 angeordnet. Das Begrenzungselement an sich wird durch die Ebene 28 der Waferhalterung 23 gebildet. Bis zu dieser Ebene kann Metall während der galvanischen Abscheidung des Metalls auf die auf der Unterseite des Wafers 21 angeordnete Keimschiclit aufwachsen. Vorteilhaft wird eine Planarisierung der Unterseite zur Entfernung des Kupfers auf diese Weise ebenfalls entbehrlich.

### Drittes Ausführungsbeispiel:

Fig. 3 zeigt einen über das erfindungsgemäße Verfahren hergestellten Biochip 2 auf einer Trägerplatine 1. Im unteren Teil von Fig. 2 ist der auf der Trägerplatine 1 angeordnete Biochip 2 auch in einer Ausschnittvergrößerung jeweils im Schnitt gezeigt.

Vor der Herstellung der Durchkontaktierungen 4 und der Leiterbahnen 6 auf der Oberseite des Biochips 2 werden die Feldeffekttransistoren zur Bildung eines Array 3 auf der Oberseite des Biochips 2 prozessiert.

Über das Feldeffekttransistorarray 3 werden die Signale über die galvanisierten Leiterbahnen 6 von der Oberseite des Biochips 2 über die Durchkontaktierungen 4 auf die Unterseite des Biochips 2 geführt. Die Signale werden über die Leiterbahnen 7 auf der Trägerplatine 1 an eine Auswerteelektronik (nicht dargestellt) weitergeleitet.

Mit Bezugszeichen 8 ist die Lötstelle zwischen der Durchkontaktierung 4 und der Leiterbahn 7 auf der Trägerplatine 1 bezeichnet. Der Biochip 2 wird auf der Trägerplatine 1 durch Flip-Chip-Verbindung mit Leitkleben (kaltes Löten) befestigt.

Im oberen Teil der Fig. 3 ist eine Aufsichtsdarstellung des Chips an die Trägerplatine gezeigt. Nur eine von insgesamt 16 Durchkontaktierungen 4 auf der Trägerplatine 1 ist mit dem Bezugszeichen gekennzeichnet.

Neben der Verwendung für Biochips ist auch die Anwendung des erfindungsgemäßen Verfahrens zur Herstellung von Multichip-Modulen (MCM) möglich. Ziel dieser Technik ist es, mehrere strukturierte Chips übereinander zu schichten und untereinander elektrisch zu verbinden. Auch hierbei ist die Zugänglichkeit der Oberflächen sehr wichtig. Durch diesen dreidimensionalen Aufbau kann die für Halbleiterschaltungen nutzbare Siliziumfläche stark vergrößert werden.

Das erfindungsgemäße Verfahren und die auf diese Weise bereit gestellten Wafer sind daher vorteilhaft zur Herstellung von Biochips besonders geeignet. Biochips benötigen bei Ausführungen, die mit einer möglichst geringen Fluidmenge arbeiten müssen, regelmäßig die genannten Mikrofluidiken für die Portionierung und Positionierung der Analyten aus einer Probenflüssigkeit hin zu den Feldeffekttransistoren des Chips. Für die Mikrofluidiken ist auf Grund des Herstellungsverfahrens ausreichend Platz an der Oberfläche des Biochips.

Besonders vorteilhaft können die Mikrofluidiken nach der Herstellung der Biochips zusammen mit diesen in einem Schritt vereinzelt werden. Hierzu wird z. B. ein Spritzgussteil mit so vielen Mikrofluidiken wie Biochips vorhanden auf den Wafer aufgesetzt und anschließend beide Bauteile gleichzeitig, z. B. durch Zerschneiden der Wafer, in einzelne Chips nebst aufgesetzter Mikrofluidik vereinzelt.

Eine Vielzahl der durch das erfindungsgemäße Verfahren hergestellter Trägermaterialien können vorteilhaft platzsparend auch zur Herstellung von Chipstapel oder für 3D-integrierte Schaltkreise verwendet werden.

## Patentansprüche

1. Verfahren zur Herstellung von Durchkontaktierungen (14, 17, 19) und Leiterbahnen (20) eines Trägermaterials (11) mittels galvanischer Abscheidung von Metall, mit den Schritten:
- auf der Oberseite und der Unterseite des Trägermaterials (11) werden insbesondere im Bereich um die Bohrungen (15) für die Durchkontaktierungen (14, 17, 19) elektrisch voneinander, isolierte Bereiche einer Keimschicht (13, 16) angeordnet,
- es wird ein elektrischer Kontakt der Keimschicht (13) auf einer ersten Seite des Trägermaterials (11) zu einem Galvanisierungsbad bereit gestellt und Metall auf dieser Keimschicht (13) abgeschieden,
- durch Anordnung eines Begrenzungselements (18) mit einem Abstand (X) zur ersten Seite des Trägermaterials wird die maximale Schichtdicke des abgeschiedenen Metalls auf den Abstand begrenzt,
- die Abscheidung von Metall wird fortgesetzt, bis es die auf der zweiten Seite des Trägermaterials (11) angeordnete Keimschicht (16) kontaktiert,
- die Durchkontaktierungen (14, 17, 19) und die Leiterbahnen (20) auf der zweiten Seite des Trägermaterials (11) werden durch weitere Abscheidung gleichzeitig fertig gestellt.

2. Verfahren nach Anspruch 1,
bei dem Bereiche der Keimschicht (13, 16) mit einem Resist, insbesondere einem Festresist, bedeckt werden, an denen keine Abscheidung von Metall erfolgen soll.

## Claims

1. Method for the production of vias (14, 17, 19) and conductor tracks (20) of a substrate (11) by means of galvanic deposition of metal with the stages:
- on the upper side and the underside of the substrate (11) a seed layer (13, 16) is arranged, particularly in the area around the drilled holes (15) for the vias (14, 17, 19) of areas that are electrically insulated from one another,
- an electrical contact of the seed layer (13) for a galvanising bath is made available on a first side of the substrate (11) and metal deposited on this seed layer (13),
- by placing a limiting element (18) at a distance (X) from the first side of the substrate, the maximum layer thickness of the deposited metal is limited to the distance,
- the deposition of metal is continued until it contacts the seed layer (16) arranged on the second side of the substrate (11),
- the vias (14, 17, 19) and the conductor tracks (20) on the second side of the substrate (11) are completed at the same time by further deposition.

2. Method in accordance with Claim 1, in which the areas of the seed layer (13, 16) are covered with a resist, in particular a solid resist, on which no deposition of metal shall take place.

## Revendications

1. Procédé de réalisation d'interconnexions verticales (14, 17, 19) et de pistes conductrices (20) dans un matériau support (11) par dépôt galvanique de métal, comprenant les étapes suivantes :
- sur le dessus et le dessous du matériau support (11), on dispose, en particulier dans la zone située autour des perçages (15) destinés aux interconnexions verticales (14, 17, 19), des zones électriquement isolées les unes des autres d'une couche de germination cristalline (13, 16),
- on réalise un contact électrique de la couche de germination cristalline (13) sur une première face du matériau support (11) avec un bain de galvanisation et on dépose du métal sur cette couche de germination cristalline (13),
- par la mise en place d'un élément de limitation (18) à une distance (X) de la première face du matériau support, on limite l'épaisseur de couche maximale du métal déposé à une valeur égale à cette distance,
- on poursuit le dépôt du métal jusqu'à ce qu'il vienne en contact avec la couche de germination cristalline (16) disposée sur la deuxième face du matériau support (11),
- par un dépôt supplémentaire, on réalise en même temps les interconnexions verticales (14, 17, 19) et les pistes conductrices (20) sur la deuxième face du matériau support (11).

2. Procédé selon la revendication 1, dans lequel les zones de la couche de germination cristalline (13, 16) dans lesquelles il ne doit pas être déposé de métal sont recouvertes d'un vernis épargne, en particulier d'un vernis épargne solide.
